# EUROPÄISCHE PATENTSCHRIFT

(11) **EP 3 346 493 B1**
(45) Veröffentlichungstag und Bekanntmachung des Hinweises auf die Patenterteilung: **18.08.2021**
(21) Anmeldenummer: 18150174.3
(22) Anmeldetag: 03.01.2018
(51) Int. Cl.: H01L 23/552, H01L 23/66, H01L 23/538, H01L 21/60, H01L 23/485

(54) **WAFER LEVEL PACKAGE MIT INTEGRIERTEN ANTENNEN UND MITTEL ZUM SCHIRMEN**
WAFER LEVEL PACKAGE WITH INTEGRATED ANTENNAS AND SHIELDING MEANS
ENCAPUSLATION SUR TRANCHE POURVUE D'ANTENNE INTÉGRÉE ET MOYEN DE BLINDAGE

(30) Priorität: 05.01.2017 DE 102017200122
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: NDIP, Ivan, 13469 Berlin (DE); BRAUN, Tanja, 14052 Berlin (DE)
(74) Vertreter: Pfitzner, Hannes

(56) Entgegenhaltungen:
- DE-A1-102013 108 075
- US-A1- 2008 186 247
- US-A1- 2013 292 808
- US-A1- 2015 380 386

## Beschreibung

Die vorliegende Erfindung bezieht sich auf ein Wafer Level Package mit integrierter Antenne sowie auf ein entsprechendes Herstellungsverfahren. Bevorzugte Ausführungsbeispiele beziehen sich auf eine miniaturisierte Fan-Out-Panel-/Wafer Level-basierte System-Integrationsplattform mit integrierter Antenne.

Ausführungsbeispiele der vorliegenden Erfindung beziehen sich auf ein Wafer Level Package mit zumindest einem integrierten Antennenelement sowie auf ein entsprechendes Herstellungsverfahren. Bevorzugte Ausführungsbeispiele beziehen sich auf einen Fan-Out-Panel-/Wafer Level-basierte System-Integrationsplattform mit Superstrate integrierten Antennen ohne Umverdrahtungsebene.

Die Antennen in eWLB und InFO können nicht optimiert werden, ohne die Abmessungen der RDL und des Moldmaterials anzupassen, was die Designfreiheit der Plattform begrenzt.

Sowohl in eWLB als auch in InFO sind die Felder der integrierten Antennen nicht von den Chips und anderen integrierten Komponenten geschirmt. Die unerwünschte Wechselwirkung kann zu EMV Problemen führen.

In eWLB kann die Strahlung einer integrierten Antenne nicht die ganze Halbkugel (die gesamte horizontale und vertikale Ebene) abdecken, ohne unerwünschte Kopplung mit anderen integrierten Komponenten zu verursachen. Der Grund dafür ist, dass andere Komponenten auf derselben Ebene wie die Antennen integriert sind. Deshalb besteht der Bedarf nach einem verbesserten Ansatz.

Die US 2013/292808 beschreibt ein abgeschirmtes Paket mit integrierter Antenne.

Die DE 10 2013 108 075 beschreibt ein Chipgehäuseverfahren zum Herstellen eines Chips.

Aufgabe der vorliegenden Erfindung ist es, ein Konzept zur Integration einer Antenne in einem Wafer Level Package zu schaffen, das einen verbesserten Kompromiss aus Effizienz, Designfreiheit und EMV-Unempfindlichkeit darstellt.

Die Aufgabe wird durch die unabhängigen Patentansprüche gelöst.

Die vorliegende Erfindung schafft ein Wafer Level Package mit integrierter Antenne gemäß Anspruch 1. Das Wafer Level Package hat eine Kontaktierungsschicht, eine Antennenschicht mit integrierter Antenne sowie eine zwischen der Kontaktierungsschicht und der Antennenschicht angeordnete Chipschicht, umfassend zumindest einen Chip. Zwischen der Antennenschicht und der Chipschicht sind Mittel zum Schirmen, wie z. B. eine Schirmebene oder allgemein ein Schirm vorgesehen. Zwischen den Mitteln zum Schirmen und der Chipschicht ist auch eine Umverdrahtungsschicht ausgebildet.

Der vorliegenden Erfindung liegt die Erkenntnis zugrunde, dass bei einem schichtweisen Aufbau von Antennenteil und Chipteil es vorteilhaft ist, wenn zwischen diesen zwei Schichten eine Schirmung vorgesehen ist, die sowohl die Chips/ICs der Chipschicht von der Strahlung der Antenne schützt und auch umgekehrt die Antenne vor EMV-Beeinflussungen der Chips bewahrt. Die Anordnung der Umverdrahtungsebene, auf der der Antenne abgewandten Seite des Schirms ist vorteilhaft, da so dieselbe gegenseitige Beeinflussungen durch den Schirm verhindert werden können. Zusätzlich sei erwähnt, dass die Entkopplung von Chiplayer zu Antennenlayer es ermöglicht, beide Ebenen relativ flexibel zu gestalten, da nun kaum oder wenig Wechselwirkungen berücksichtigt werden müssen.

Entsprechend Ausführungsbeispielen ist die Chipebene durch einen oder mehrere Chips in Kombination mit einem Moldmaterial geformt. Da die Umverdrahtungsebene auf der der Antenne zugewandten Seite vorliegt, kann entsprechend Ausführungsbeispielen eine Verbindung zwischen der Umverdrahtungsebene und der Kontaktierungsebene beispielsweise durch Vias erfolgen. Aufseiten der Kontaktierungsebene sind.

Mittel zur Temperaturabfuhr für den Chip vorgesehen.

Entsprechend folgenden Ausführungsbeispielen kann zwischen der Antennenschicht und den Mitteln zum Schirmen ein Dielektrikum vorgesehen sein. Dieses Dielektrikum kann entsprechend zusätzlichen Ausführungsbeispielen auch perforiert sein, um so Filterfunktionalität zu ermöglichen. Bei diesem Konzept ist es vorteilhaft, dass sowohl das Material als auch die Dicke des Dielektrizitätslayers variiert werden kann, ohne dass die weiteren Schichten dadurch beeinflusst werden. An dieser Stelle sei auch angemerkt, dass entsprechend Ausführungsbeispielen die Antennenebene auch eine Mehrzahl von Antennenelementen umfassen kann. Analog zu dem Dielektrikum kann auch eine Isolationsschicht zwischen der Chipebene und der oben erläuterten Umverdrahtungsebene vorgesehen sein. Entsprechend wiederum weiteren Ausführungsbeispielen erfolgt die Kontaktierung beispielsweise über ein Via, das durch die Mittel zur Schirmung und eventuell vorhandene weitere Schichten (Dielektrizitätsschicht und Isolationsschicht) durchragt. Dieser Via verbindet also den Chip, wie z. B. den RF-Chip der Chipebene mit ein oder mehreren Antennenelementen. Alternativ kann entsprechend weiteren Ausführungsbeispielen die eine oder mehreren Antennen mittels elektromagnetischer Kopplung kontaktiert werden.

Die Erfindung schafft auch ein Verfahren zur Herstellung eines Wafer Level Package mit integrierter Antenne gemäß Anspruch 14. Bei diesem Verfahren wird zuerst die Kontaktierungsschicht zusammen mit der Chipschicht hergestellt, bevor dann die Antennenschicht auf der Chipschicht mit dazwischen angeordneten Mitteln zum Schirmen angeordnet werden. Hierbei kann das Aufbringen der Antennenschicht beispielsweise mittels Laminieren, flächigem Kleben oder über ein Glassubstrat aufgebracht werden.

Weiterbildungen sind in den Unteransprüchen definiert. Ausführungsbeispiele der vorliegenden Erfindung werden nachfolgend anhand der Zeichnungen erläutert. Es zeigen:
- Fig. 1: eine schematische Darstellung eines Wafer Level Package mit integrierter Antenne gemäß einer Basisvariante, die die Erfindung nicht darstellt, die aber zum besseren Verständnis derselben herangezogen werden kann;
- Fig. 2a-b: schematische Schnittdarstellungen von Wafer Level Packages mit integrierter Antenne gemäß erweiterten Varianten, die die Erfindung nicht darstellen, die aber zum besseren Verständnis derselben herangezogen werden können;
- Fig. 2c-d: schematische Darstellungen von Wafer Level Packages mit integrierter Antenne gemäß Ausführungsbeispielen der vorliegenden Erfindung;
- Fig. 2e: eine schematische Schnittdarstellung eines Wafer Level Package mit Linse gemäß einer Variante, die die Erfindung nicht darstellt, die aber zum besseren Verständnis derselben herangezogen werden kann;
- Fig. 2f: eine schematische Schnittdarstellung eines Wafer Level Package mit Gehäuse gemäß einer Variante, die die Erfindung nicht darstellt, die aber zum besseren Verständnis derselben herangezogen werden kann; und

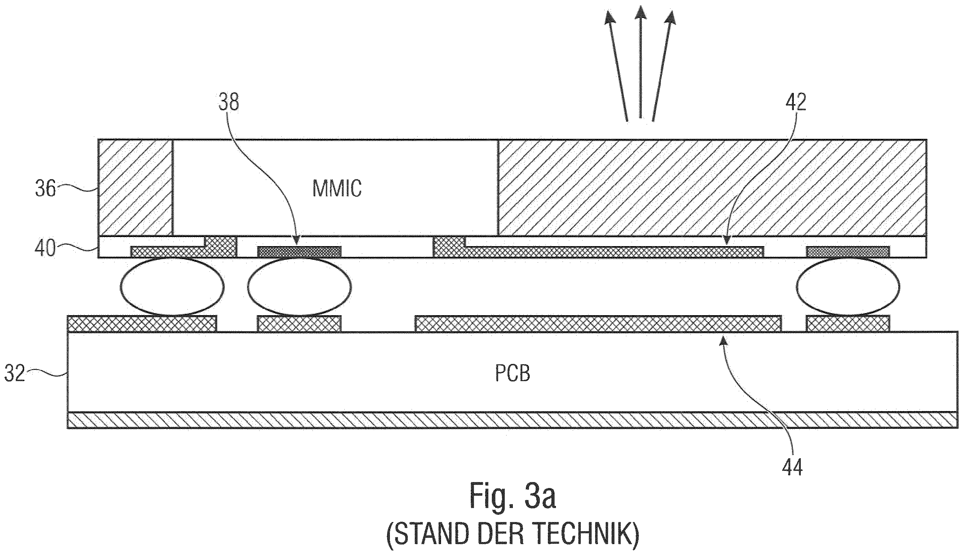

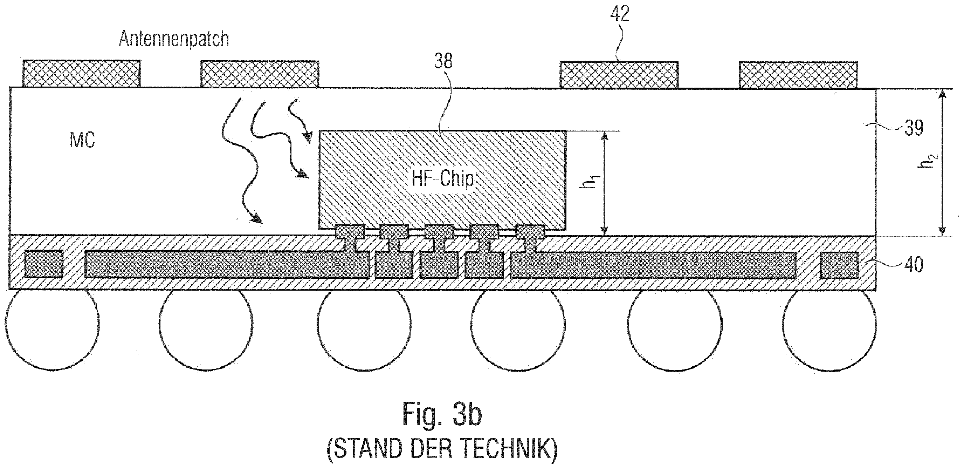

- Fig. 3a und 3b: schematische Darstellungen von Wafer Level Packages gemäß Stand-der-Technik-Ansätzen.

Bevor nachfolgend Ausführungsbeispiele der vorliegende Erfindung anhand der beiliegenden Zeichnungen erläutert werden, sei darauf hingewiesen, dass gleichwirkende Elemente und Strukturen mit gleichen Bezugszeichen versehen sind, so dass die Beschreibung derer aufeinander anwendbar bzw. austauschbar ist.

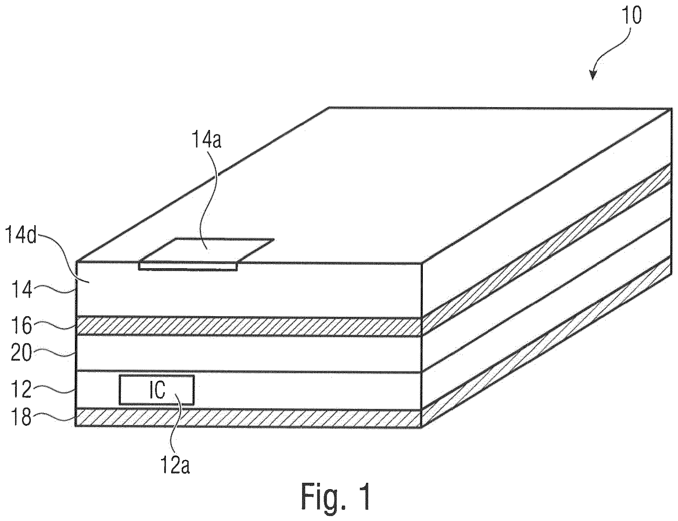

Fig. 1 zeigt ein Wafer Level Package 10 mit einer Chipschicht 12, einer Antennenschicht 14 sowie Mitteln zum Schirmen (vgl. Bezugszeichen 16), die zwischen der Chipschicht 12 und der Antennenschicht 14 angeordnet sind. Zusätzlich weist das Wafer Level Package 10 eine Kontaktierungsschicht 18 auf, die auf der Unterseite der Chipschicht 12, das heißt auf der der Antennenschicht 14 gegenüberliegenden Seite der Chipschicht 12 angeordnet ist.

Die Antennenschicht 14 umfasst zumindest eine integrierte Antenne oder eine Antennenarray/Gruppenstrahler, hier die integrierte Antenne 14a und bevorzugt, aber nicht zwingenderweise ein Dielektrikumbereich 14d, der im Regelfall zwischen der Antenne 14a und der Schicht 16 mit Mitteln zum Schirmen angeordnet ist.

In dieser Basisvariante sind die Mittel zum Schirmen durch eine Schirmschicht 16, das heißt beispielsweise durch eine Metallisierungsebene gebildet.

Der Chiplayer 12 umfasst eine oder mehrere Chips, hier den Chip 12a (wie z. B. einen RF-Chip), der in die Schicht 12 eingebettet ist. Das Einbetten kann beispielsweise mittels eines Fan-Out-Panel-/Wafer-Level-Prozess unter Zuhilfenahme eines Polymers, wie z. B. eines Moldmaterials erfolgen. Entsprechend Varianten kann zwischen der Schirmschicht 16 und der Chipschicht 12 auch noch eine weitere Schicht 20 vorgesehen sein, die z. B. eine Umverdrahtungsebene und/oder Isolationslagen umfasst.

Der Chip 12a wird beispielsweise über diese Umverdrahtungsebene in der Schicht und/oder über die Kontaktierungsschicht 18 verbunden. Entsprechend Varianten kann die Umverdrahtungsebene der Schicht 20, z. B. über Vias mit der Kontaktierungsschicht 18 verbunden sein. Entsprechend weiteren Varianten kann auch ein Via sich von dem Chip 12a zu der integrierten Antenne 14a erstrecken, um dieses zu kontaktieren.

Der hier beschriebene Aufbau bietet den Vorteile bzgl. Vollintegration der Antennen 14a, Chips 12a, passive Komponenten und andere Systemkomponenten in die Fan-Out-Panel-/Wafer Level-basierte System-Integrationsplattform bzw. Modul 10. Dadurch ist die Funktionalität der Plattform bzw. des Moduls 10 komplett unabhängig von der Leiterplatte. Das ist nicht der Fall bei anderen state-of-the-art FO-WLP Modulen wie z. B. eWLB. Hier wird der Reflektor der Antennen auf der Leiterplatte integriert. Dadurch hängt die Funktionalität der Antennen und auch der Plattform bzw. des Moduls von den Abmessungen der BGA Balls, ihren Prozessschwankungen und auch von der Leiterplatte ab.

Da optional ein separates Substrat 14 für integrierte Antennen 14a benutzt wird, können diese Antennen 14a optimiert werden, ohne den restlichen Aufbau der Plattform bzw. des Moduls 10 zu verändern. Das ist nicht der Fall bei anderen FO-WLP Modulen, z. B. um Antennen 14a in eWLB und InFO zu optimieren, müssen die Abmessungen der RDL und Moldmaterial angepasst werden.

Die Felder der integrierten Antennen 14a sind komplett geschirmt von den Chips 12a, passiven und anderen Komponenten, die in die Fan-Out-Panel-/Wafer Level-basierte System-Integrationsplattform bzw. Modul integriert sind. Dadurch werden EMV Probleme vermieden. Das ist nicht der Fall in anderen Fan-Out Modulen. Weder in InFo-WLP noch in eWLB sind die Antennen 14a von den Chips 12a geschirmt.

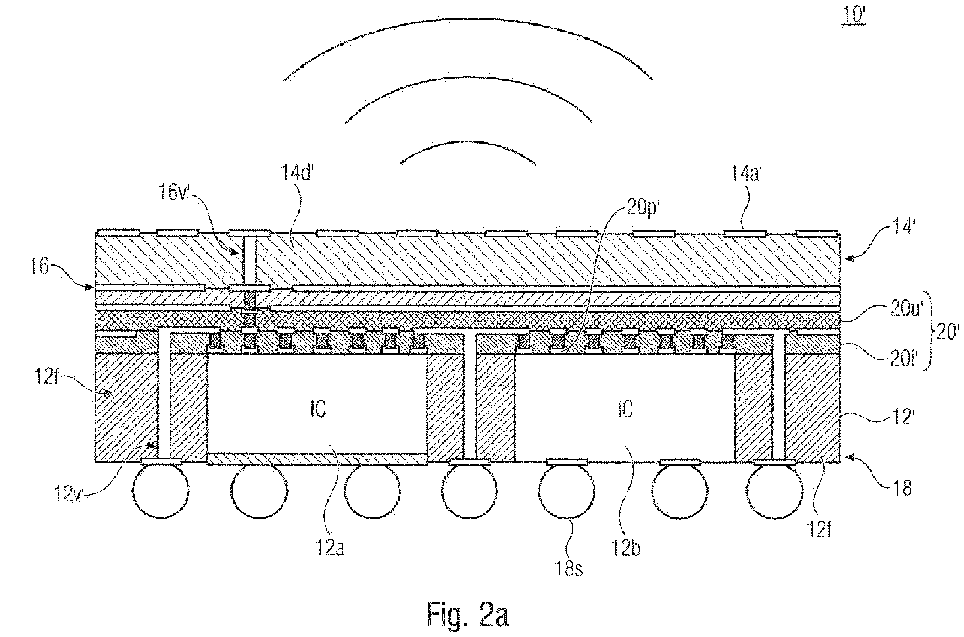

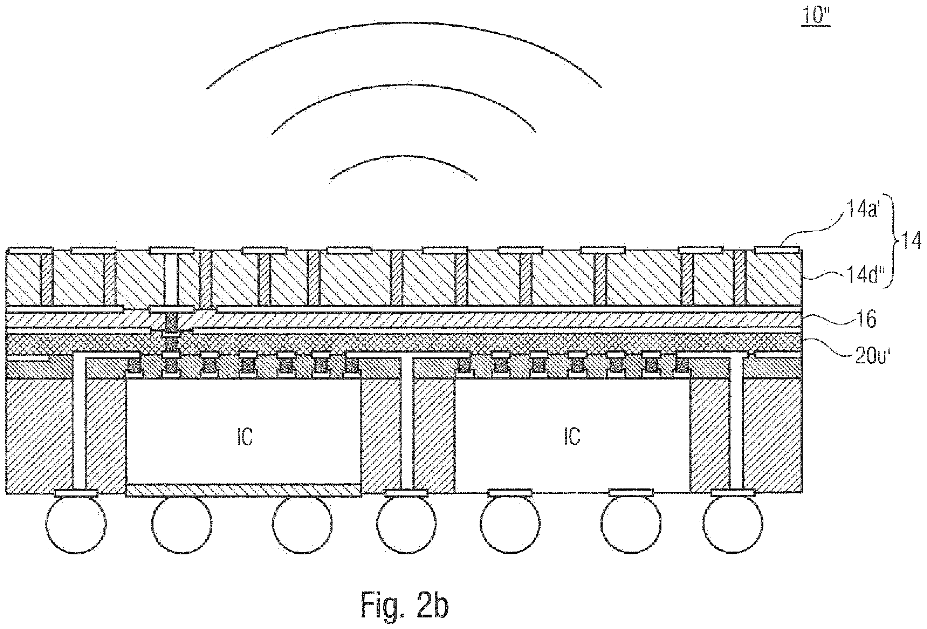

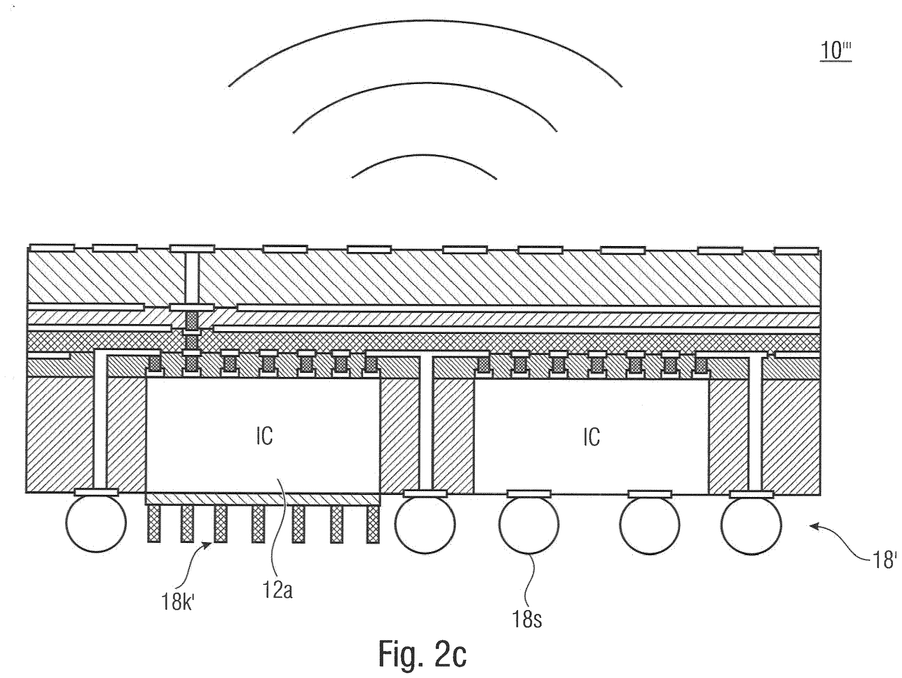

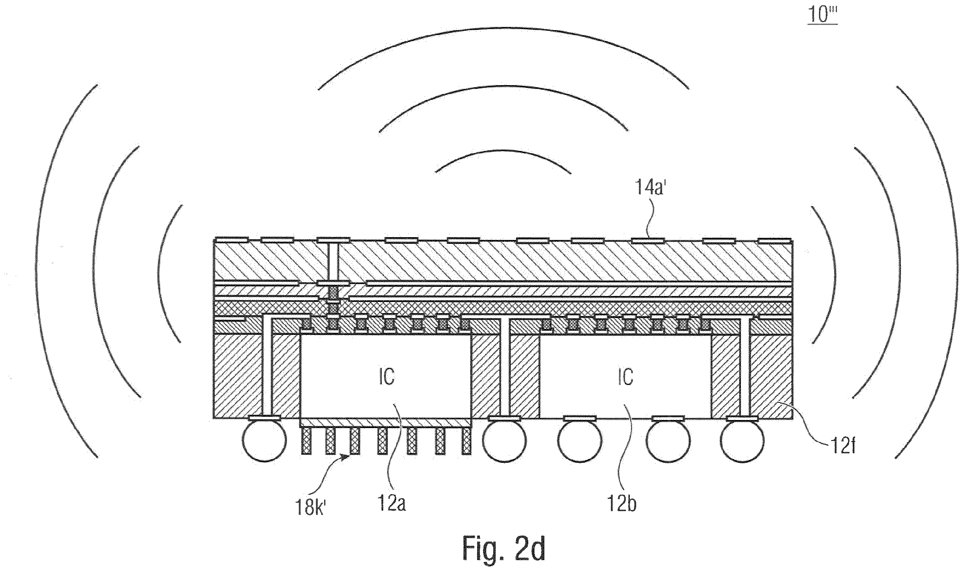

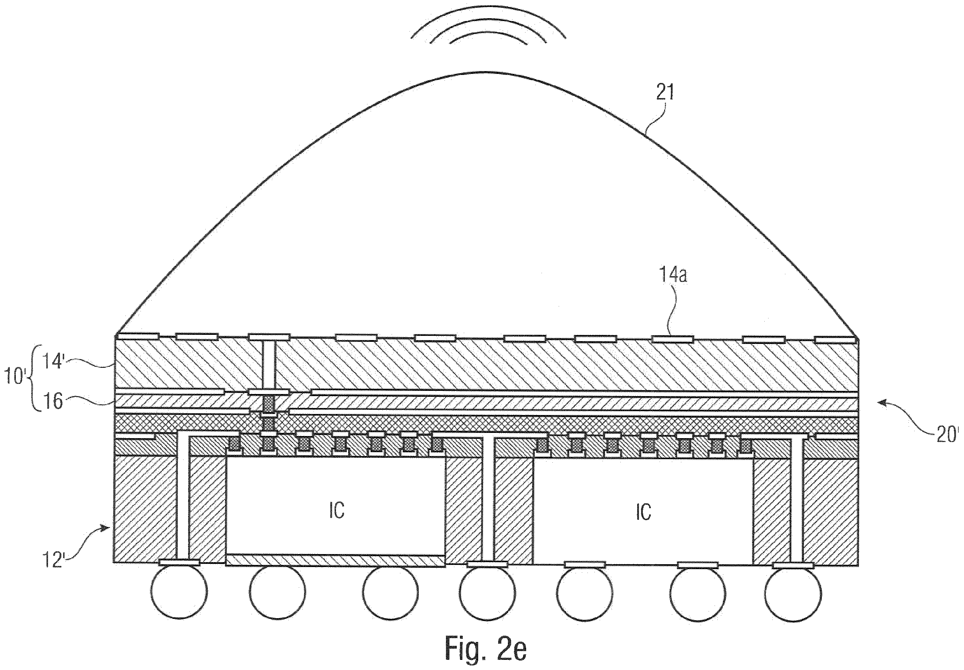

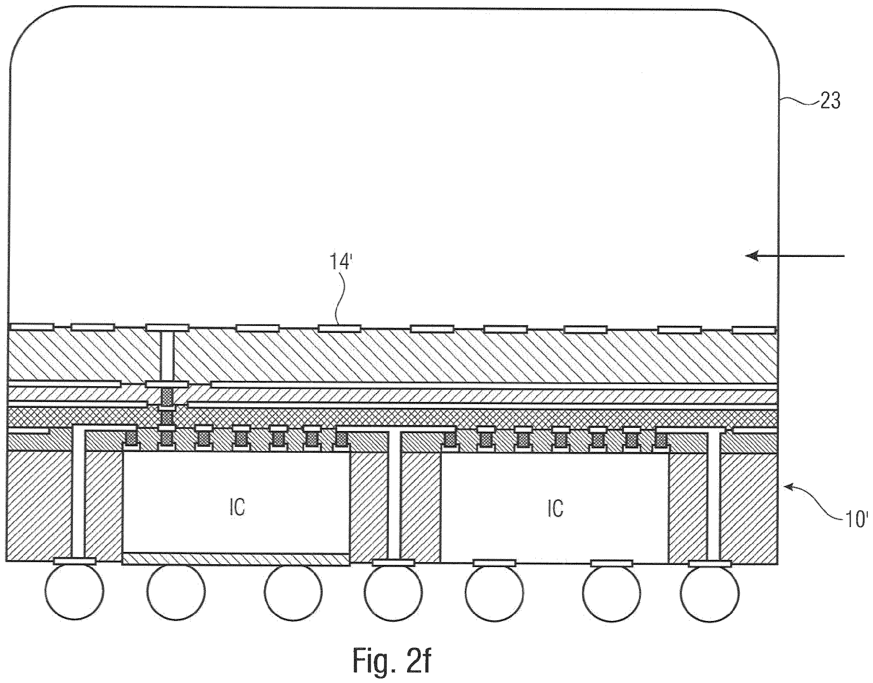

Bezug nehmend auf Fig. 2 werden nun erweiterte Varianten und Ausführungsbeispiele erläutert

Fig. 2a zeigt ein Wafer Level Package 10' mit der Chipschicht 12', der Antennenschicht 14', wobei zwischen Chipschicht 12' und Antennenschicht 14' zum einen die Schirmungsschicht 16 sowie die Umverdrahtungsebene 20' vorgesehen ist. Zusätzlich ist auch die Kontaktierungsebene 18 auf der Unterseite der Chipschicht 12' angeordnet.

Die Chipschicht 12' umfasst die zwei Chips 12a und 12b, die in einem sogenannten Fan-out-Bereich 12f, umfassend andere ICs, passive oder andere Systemkomponenten integriert ist. Dieser Fan-out-Bereich 12f ist typischerweise durch ein Polymer bzw. Moldmaterial gebildet.

Die Antenne 14a' erstreckt sich über die gesamte Antennenschicht 16 und hier insbesondere über die Oberfläche derselben. Die Antennenschicht 14ist beispielsweise durch ein Glassubstrat, ein Polymer, ein Laminat, etc. gebildet, das das jeweilige Dielektrikum 14' für die Antenne 14a' bildet. Wie zu erkennen ist, sind die einzelnen Antennenbereiche bzw. Antennenebenen voll in das Dielektrikum 14d' eingebettet.

Um die Antenne 14a' zu kontaktieren, ist die Antenne 14' über einen vertikalen Via mit dem Chip 12a', hier einem HF-Chip, verbunden. Wie die Darstellung zu erkennen gibt, stellt der Via 16v' die kürzeste Verbindung dar. Dieser kurze Signalweg mit wenigen Diskontinuitäten ermöglicht die Signalintegrität, auch für Millimeterwellen und Terahertzsignale. Alternativ kann zu der vertikalen Sonde 16v' auch eine elektromagnetische Kopplung, z. B. über eine Apparaturkopplung oder eine Nahfeldkopplung realisiert sein. Weiter wäre es auch denkbar, dass zusätzlich zu der vertikalen Vias 16v' ein planarer Verbinder, wie z. B. eine Transmission-Line eingesetzt wird.

Die Schicht 20' umfasst zum einen die Umverdrahtungsebene 20u', z. B. für die Signalverteilung und die Stromversorgung sowie den Isolator 20i', der zwischen der Chipebene 12' und der Umverdrahtungsebene 20' angeordnet ist. Die Umverdrahtungsebene 20' besteht entsprechend weiteren Varianten aus ein oder mehreren Metall- und dielektrischen Isolationsschichten. Zusätzlich können in die Umverdrahtungsebene 20' bzw. insbesondere in die Metallisierungsebene 20u' passive Komponenten, wie z. B. Induktivitäten, Widerstände, Kondensatoren, Filter oder andere Elemente integriert sein. Alternativ wäre eine Einbettung dieser passiven Elemente in das Moldmaterial der Chipebene 12' denkbar, wobei dann diese passiven Elemente über die Umverdrahtungsebene 12u' kontaktiert werden.

An der Vorderseite sind die ICs 12a und 12b über Pads 20p' mit der Umverdrahtungsebene 20u' verbunden. Die Umverdrahtungsebene 20u' ist des Weiteren über Vias 12v', die durch das Moldmaterial 12f bzw. allgemein durch die Chipebene 12' hindurchragen, mit der Kontaktierungsschicht 18 kontaktiert. Über die elektrisch leitfähige Durchkontaktierung 12v' durch das eingebettete Polymer (Moldcompound) 12f lassen sich die Umverdrahtungslagen 20u' inklusive der Antennenlage 14a' auf die Packagerückseite 18 zur Ankontaktierung zum Substrat routen. Diese Kontaktierungsschicht 18 umfasst beispielsweise Solderballs bzw. Thermalballs, über die das gesamte Package 10' kontaktiert wird. Bei dieser Variante ist es auch so, dass auf der Unterseite der ICs 12a und 12b ebenfalls die Solderballs/Lotkugeln 18s bzw. die Kontaktierungselemente der Kontaktierungsschicht 18 vorgesehen sind, so dass die ICs 12a und 12b beidseitig kontaktierbar sind.

Oberhalb der Umverdrahtungsebene 20u' befindet sich das Antennensubstrat 16+14', das aus mindestens zwei Metalllagen 16 und 14a' (Mittel zum Schirmen und Antenne) sowie eine dazwischen angeordneten Dieleketrikschicht 14d' ausgeführt ist. Die Metalllage 16 dient, wie bereits oben erläutert, zur Schirmung der Antennenfelder von den integrierten Komponenten. Die Antenne 14a' kann entweder aus einem oder aus mehreren strahlenden Elementen (Gruppenstrahler) aufgebaut sein und wird, wie bereits erläutert, entweder galvanisch mit Hilfe einer Leitung oder eines Vias (Probe Feed) oder eines elektromagnetische Kopplung (z. B. Aperture-Coupled, Proximity Feed) angeregt. Je nach gewünschter Abstrahlcharakteristik ermöglicht das Antennensubstrat 16+14' die Realisierung von unterschiedlichen Antennenkonfigurationen, z. B. Patch, Grid-Array, Schlitz, Substratintegrierte Wellenleiter (SIW)-basierte Antennen, Dipol, Monopol, Yagi-Uda, Vivaldi, usw. Die integrierten Antennen können entsprechend weiteren Varianten auch "intelligent", d. h. rekonfigurierbar, steuerbar, adaptiv bzw. smart ausgeführt sein. Die hierfür regelmäßig erforderliche Elektronik (z. B. Schaltungen und/oder Dioden) für die Rekonfigurierbarkeit kann entweder in dem Antennensubstrat 16+14', in der Umverdrahtungsebene 20', dem Polymersubstrat 12' (also zusammen mit den ICs 12a und 12b) mitintegriert sein. Hierbei wäre es auch entsprechend weiteren Varianten denkbar, dass die Elektronik für die Steuerung der Antenne (z. B. Phasenschieber) entweder in der Umverdrahtungsebene 20' bzw. in der Chipebene 12' angeordnet ist.

Ausgehend von der hier vorgestellten Struktur des Wafer Level Package 10' kann in Abhängigkeit von der Antennenkonfiguration die Antenne aus der Oberflächenebene herausstrahlen, zur Seite herausstrahlen (Azimutebene) oder in beide Richtungen. Wie illustriert, erfolgt bei der hier vorliegenden Variante eine Abstrahlung insbesondere aus der Hauptoberfläche der Antenne 14a' heraus.

Die Plattform bzw. das Modul 10' ermöglicht die Abstrahlung der integrierten Antennen 16a' in die ganze Halbkugel (d. h. in die gesamte azimutale und vertikale Ebene), ohne unerwünschte Kopplung mit anderen integrierten Komponenten zu verursachen. Das ist möglich, weil keine anderen Komponenten auf Antennenebene 14' integriert sind. Das ist nicht der Fall, z. B. mit eWLB, da die ICs 12a, 12b und andere Komponenten auf derselben Ebene wie die Antennen 14a' integriert sind. Wenn bei obigen Varianten 10 und 10' davon ausgegangen wurde, dass eine Abstrahlung der Antenne 14a' nur aus der Hauptoberfläche heraus erfolgt, kann, wie beispielsweise in Fig. 2d dargestellt, auch eine Abstrahlung zur Seite erfolgen. Hierbei sei angemerkt, dass das Wafer Level Package aus Fig. 2d mit den Bezugszeichen 10"' versehen ist und im Zusammenhang mit Fig. 2c im Detail erläutert werden wird.

In Fig. 2b ist eine modifizierte Variante des Wafer Level Packages 10', nämlich das Wafer Level Package 10" dargestellt. Dieses unterscheidet sich von dem Wafer Level Package 10' im Hinblick auf das Antennensubstrat in der Antennenschicht 14". Das Antennensubstrat umfasst die Elemente "Antenne 14a' "Dielektrikum 14d" sowie Mittel zum Schirmen 16. Wie bereits oben erläutert, kann das Antennensubstrat bzw. insbesondere das Dielektrikum 14d" ein Polymermaterial umfassen, ein Glasmaterial, ein HF-Laminat oder ein anderes geeignetes HF-Material. In dieser Variante ist die dielektrische Schicht 14d" mit periodischen Löchern versehen, d. h. perforiert. Dadurch verhält sich das Substrat 14+16 wie eine photonische Bandgap-Struktur, die zur Filterung der Oberflächenwellen und damit zur Verbesserung der Abstrahlcharakteristik führt. Weiterhin sinkt der Wert der effektiven Primitivität des Substrats durch die Löcher. Dadurch erhöht sich die Kantenlänge der Antennenstruktur bei höheren Frequenzen und der Einfluss der Prozessschwankungen wird geringer. Die Abstrahlcharakteristik der Antenne 16a' kann auch durch Integration von elektromagnetischen Bandgap-Strukturen (EBG) entweder im Antennensubstrat 14"+16 oder der Umverdrahtungsebene 20u' verbessert werden.

Fig. 2c zeigt ein Ausführungsbeispiel der vorliegenden Erfindung und ist eine weitere Modifikation ausgehend von dem Wafer Level Package 10' nämlich das Wafer Level Package 10"'. Bei diesen ist im Vergleich zu dem Wafer Level Package 10' die Kontaktierungsebene 18 (jetzt 18') modifiziert ausgelegt. Die Modifikation ist derart gewählt, dass im Bereich des Chips 12a statt den Kontakten zur Unterseitenkontaktierung Mittel zur Wärmeabfuhr, hier ein Kühlkörper 18k' vorgesehen ist, um die Wärme von dem Chip 12a abzuführen. Der Kühlkörper 18k' spreizt die Wärme in die Umgebung unter dem Chip 12a und die Lotkugeln 18f leiten die Wärme in das nächste Package-Level, z. B. das System-Board weiter.

Entsprechend Ausführungsbeispielen kann zwischen Chip und dem Kühlkörper 18k' ein thermisch leitfähiges Material vorgesehen sein. An dieser Stelle sei angemerkt, dass entsprechend weiteren Ausführungsbeispielen auch eine Wärmeabfuhr über die oben erläuterten Lötkugeln 18s möglich wäre, wobei dann im Regelfall auch ein thermisch leitfähiges Material eingesetzt wird.

Aus Herstellungssicht gibt es unterschiedliche Möglichkeiten, wie die Oberfläche des Chips 12a freigelegt wird. Entsprechend einer ersten Variante kann die Chiprückseite direkt im Moldprozess freigestellt werden. Alternativ hierzu wäre auch ein nachträgliches Rückschleifen möglich. Die beim Kühlkörper 18k' typischerweise erforderliche Metallisierung kann entweder beim Chip 12a schon vor dem Packaging vorgesehen sein oder z. B. über eine Dünnfilmverdrahtungslage oder eine Sputerlage mit galvanischer Verstärkung aufgebracht werden.

Auch wenn obige Varianten und Ausführungsbeispiele insbesondere zusammen mit der Vorrichtung erläutert wurden, schafft ein weiteres Ausführungsbeispiel ein entsprechendes Herstellungsverfahren. Hierbei wird in einem ersten Basisschritt des Chipsubstrat 12' zusammen mit der Kontaktierungsebene 18 bzw. 18' sowie der optionalen Umverdrahtungsebene 20' bereitgestellt. Auch die Schicht 20' bzw. nach dem Aufbringen der Schicht 20' wird dann das Antennensubstrat 14'+16 aufgebracht. Diese Antennenlage 14'+16 kann z. B. über Laminieren (HF-Substrat), schichtweise in Dünnfilmtechnik und über eine flächige Klebung (Glas) aufgebracht werden. Dabei kann die Antennenlage 14a' sowohl vor der Montage bereits strukturiert sein als auch sequentiell nach der Montage strukturiert werden. Das heißt also in anderen Worten ausgedrückt, dass das Chipsubstrat 12' mit der Umverdrahtungslage 20'mit dem Antennensubstrat 14'+16 verbunden wird. Dieses Verbinden erfolgt also auf Waferlevel.

Fig. 2e zeigt das Wafer Level Package 10' aus Fig. 2a mit Chipschicht 12', Antennenschicht 14', Schirmungsschicht 16 sowie die Umverdrahtungsebene 20'. In dieser Variante weist das Wafer Level Package 10' eine zusätzliche Linse 21 (Mittel zur Strahlformung der elektromagnetischen Welle ausgesendet durch die Antenne) auf der Oberseite (Hauptoberfläche), benachbart zur Antenne 14a'. Die Linse 21 dient zur vertikale Fokussierung des Antennenstrahls.

Fig. 2f zeigt wiederum das Wafer Level Package 10' aus Fig. 2a in Kombination mit einem auf der Oberseite (Seite der Antenne 14') angeordneten Gehäuse 23. Das Gehäuse 23 ist bevorzugt aus Glas oder einem anderen nicht schirmenden Material. Das Gehäuse 23 kann z.B. mit Luft oder einem dielektrischen Material mit geringen Verlusten gefüllt sein. Ferner kann das Gehäuse 23 auch zur Strahlformung / Fokussierung der elektromagnetischen Welle beitragen.

Sowohl Gehäuse 23 als auch Linse 21 sind zusammen und in Kombination mit allen oben erläuterten Varianten und Ausführungsbeispielen / Wafer Level Packages anwendbar

Gemäß einem weiteren Ausführungsbeispiel wird ein System geschaffen, bei dem das Wafer Level Package mit (zumindest) einem weiteren (andersartigem oder gleichem) Wafer Level Package verbunden ist. Die Vebindung erfolgt z.B. über die Kontaktierungsschicht. Das weitere Wafer Level Package kann z.B. ebenfalls ein oder mehrerer Antennen (Array) umfassen, sodass im Ergebnis eine dreidimensionale Antennenstruktur geschaffen wird.

Alle oben genannten Varianten und Ausführungsbeispiele, insbesondere die aus den Fig. 2a-d haben gemein, dass eine kurze Verbindungsstrecke 16v' ohne viele geometrische Diskontinuitäten von dem Front-End-IC 12a zu der Antenne 14a' ermöglicht werden, was zu einer guten Signalintegrität, z. B. im Millimeter-Wellenbereich oder Terahertz-Bereich führt. Die Plattform bzw. das Modul 10', 10" und 10"' ermöglicht die Integration von Antennenkonfigurationen mit beliebigen Anbringungsmöglichkeiten. Das ist insbesondere mit anderen FOWLP-Konfigurationen nicht der Fall. Des Weiteren ermöglichen, hier insbesondere im Zusammenhang mit Fig. 2c und 2d dargestellt, die oben erläuterten Strukturen eine integrierte Lösung für das thermische Management.

Die Anwendungsgebiete sind mannigfaltig. Die Plattform 10, 10', 10", 10"' bzw. das Modul kann eingesetzt werden, um drahtlose Kommunikationssysteme, die in allen Frequenzbereichen des elektromagnetischen Spektrums eingesetzt werden können, zu entwickeln, z. B. für WPAN, WLAN, Mobilfunk, Satelliten, usw.

Das kann auch eingesetzt werden, um drahtlose Sensorsysteme, die für beliebige Anwendungen in allen Frequenzbereichen des elektromagnetischen Spektrums eingesetzt werden können, zu entwickeln.

Weiterhin kann die Plattform bzw. das Modul 10-10"' eingesetzt werden, um Radarsysteme, die für beliebige Anwendungen in allen Frequenzbereichen des elektromagnetischen Spektrums eingesetzt werden können, zu entwickeln.

Wie oben bereits erwähnt, kann die integrierten Antenne als Gruppenstrahler ausgeführt sein oder ein Antennenarray, z.B. mit einer Vielzahl von Antennen (>5 oder sogar >1000,) umfassen. Hier sind die mehreren Antennen bevorzugt nebeneinander so angeordnet, dass kein oder nur ein minimaler Überlapp mit weiteren Elementen, wie den Chips entsteht.

An dieser Stelle sei angemerkt, dass obige Ausführungsbeispiele nur illustrativ sind, während der Schutzbereich durch die nachfolgenden Patentansprüche festgelegt wird.

### Referenzliste

[1] T. Meyer, G. Ofner, S. Bradl, M. Brunnbauer, R. Hagen; Embedded Wafer Level Ball Grid Array (eWLB); Proceedings of EPTC 2008, Singapore.
[2] B. Keser, C. Amrine, T. Duong, O. Fay, S. Hayes, G. Leal, W. Lytle, D. Mitchell, R. Wenzel; The Redistributed Chip Package: A Breakthrough for Advanced Packaging, Proceedings of ECTC 2007, Reno/Nevada, USA.
[3] Chung-Hao Tsai et Al., Array Antenna Integrated Fan-out Wafer Level Packaging (InFO-WLP) for Millimeter Wave System Applications", 2013 IEEE International Electronic Devices Meeting (IEDM), 9-11 Dec. 2013, pp. 25.1.1 - 25.1.4.
[4] Christopher Beck, et al., Industrial mmWave Radar Sensor in Embedded Wafer Level BGA Packaging Technology", IEEE SENSORS JOURNAL, VOL. 16, NO. 17, SEPTEMBER 1, 2016

## Patentansprüche

1. Wafer Level Package (10"') mit integrierter Antenne, mit folgenden Merkmalen:
einer Kontaktierungsschicht (18, 18');
einer Antennenschicht (14, 14') mit der integrierten Antenne; und
einer zwischen der Kontaktierungsschicht (18, 18') und der Antennenschicht (14, 14') angeordneten Chipschicht (12'), umfassend zumindest einen Chip,
wobei zwischen der Antennenschicht (14, 14') und der Chipschicht (12') Mittel zum Schirmen (16) ausgebildet sind;
wobei zwischen den Mitteln zum Schirmen (16) und der Chipschicht (12') eine Umverdrahtungsschicht (20u') ausgebildet ist, die den zumindest einen Chip mit der Kontaktierungsschicht (18, 8') elektrisch verbindet, und
wobei der Chip (12) auf einer der Antennenschicht (14, 14') gegenüberliegenden Seite Mittel zur Temperaturabfuhr in Form eines Kühlkörpers (18k') aufweist.

2. Wafer Level Package (10"') gemäß Anspruch 1, wobei die Mittel zum Schirmen (16) ein Schild umfassen.

3. Wafer Level Package (10"') gemäß Anspruch 1, wobei eine Isolationsschicht (20i') zwischen der Umverdrahtungsschicht (20u') und der Chipschicht (12') ausgebildet ist.

4. Wafer Level Package (10"') gemäß einem der vorherigen Ansprüche,
wobei die integrierte Antenne als Gruppenstrahler ausgeführt ist oder ein Antennenarray umfasst.

5. Wafer Level Package (10"') gemäß einem der vorherigen Ansprüche,
wobei die Chipschicht (12') ein Moldmaterial umfasst, das neben dem zumindest einen Chip (12) angeordnet ist.

6. Wafer Level Package (10"') gemäß einem der vorherigen Ansprüche, wobei die integrierte Antenne (14a, 14a') mittels eines Vias (16u') mit dem Chip (12) verbunden ist, das durch weitere Schichten hindurchragt,
oder wobei die integrierte Antenne (14a, 14a') mittels elektromagnetischer Kopplung mit dem Chip (12) verbunden ist.

7. Wafer Level Package (10"') gemäß einem der vorherigen Ansprüche,
wobei die Antennenschicht (14, 14') ein Dielektrikum (14d, 14d', 14d") umfasst, das zwischen der integrierten Antenne und den Mitteln zum Schirmen angeordnet ist.

8. Wafer Level Package (10"') gemäß Anspruch 7, wobei das Dielektrikum (14d, 14d', 14d") perforiert ist.

9. Wafer Level Package (10"') gemäß einem der vorherigen Ansprüche,
wobei die integrierte Antenne (14a, 14a') zumindest zwei Antennenelemente umfasst.

10. Wafer Level Package (10"') gemäß einem der vorherigen Ansprüche,
wobei die Chipschicht (12') eine Mehrzahl von Chips (12) umfasst.

11. Wafer Level Package (10"') gemäß einem der vorherigen Ansprüche,
wobei das Wafer Level Package (10, 10', 10", 10"') eine Linse (19) umfasst, die ausgebildet ist, mit der integrierten Antenne zusammenzuwirken.

12. Wafer Level Package (10"') gemäß einem der vorherigen Ansprüche,
wobei die Mittel zum Schirmen durch eine Schirmschicht geformt sind;
wobei eine Isolationsschicht (20i') zwischen der Umverdrahtungsschicht (20u') und der Chipschicht (12') ausgebildet ist.

13. System umfassend das Wafer Level Package (10"') gemäß einem der Ansprüche 1 bis 12, wobei ein weiteres Wafer Level Package über die Kontaktierungsschicht (18, 18') mit dem Wafer Level Package (10, 10', 10") verbunden ist.

14. Verfahren zur Herstellung eines Wafer Level Package (10"') mit integrierter Antenne gemäß Anspruch 1, mit folgenden Schritten:
Anordnen einer Kontaktierungsschicht (18, 18');
Anordnen einer Chipschicht (12') umfassend zumindest einen Chip (12) auf der Kontaktierungsschicht (18, 18');
Anordnen von Mittel zum Schirmen (16) auf der Chipschicht (12'); und
Anordnen einer Antennenschicht (14, 14') auf den Mittel zum Schirmen (16);
wobei zwischen den Mitteln zum Schirmen (16) und der Chipschicht (12') eine Umverdrahtungsschicht (20u') ausgebildet ist, die den zumindest einen Chip mit der Kontaktrierungsschicht (18, 8') elektrisch verbindet, und
wobei der Chip (12) auf einer der Antennenschicht (14, 14') gegenüberliegenden Seite Mittel zur Temperaturabfuhr in Form eines Kühlkörpers (18k') aufweist.

15. Verfahren gemäß Anspruch 14, wobei die Antennenschicht (14, 14') mittels Laminieren und/oder über eine flächige Klebung und/oder über ein Glas aufgebracht wird.

16. Verfahren gemäß Anspruch 14 oder 15, wobei die Mittel zum Schirmen durch eine Schirmschicht geformt sind.

## Claims

1. Wafer level package (10"') with integrated antenna, comprising:
a contacting layer (18, 18');
an antenna layer (14, 14') with the integrated antenna; and
a chip layer (12') including at least one chip arranged between the contacting layer (18, 18') and the antenna layer (14, 14'),
wherein means for shielding (16) are implemented between the antenna layer (14, 14') and the chip layer (12');
wherein a redistribution layer (20u'), which electrically connects the at least one chip to the contacting layer (18, 18'), is configured between the means for shielding (16) and the chip layer (12') and
wherein the chip (12) comprises means for temperature dissipation in the form of a cooling body (18k') on a side opposite to the antenna layer (14, 14').

2. Wafer level package (10"') according to claim 1, wherein the means for shielding (16) include a shield.

3. Wafer level package (10"') according to claim 1, wherein an isolation layer (20i') is implemented between the redistribution layer (20u') and the chip layer (12').

4. Wafer level package (10"') according to one of the preceding claims, wherein the integrated antenna is configured as antenna array or includes an antenna array.

5. Wafer level package (10"') according to one of the preceding claims, wherein the chip layer (12') includes a mold material that is arranged beside the at least one chip (12).

6. Wafer level package (10"') according to one of the preceding claims, wherein the integrated antenna (14a, 14a') is connected to the chip (12) by means of a via (16u') projecting through further layers,
or wherein the integrated antenna (14a, 14a') is connected to the chip (12) via electromagnetic coupling.

7. Wafer level package (10"') according to one of the preceding claims, wherein the antenna layer (14, 14') includes a dielectric (14d, 14d', 14d") which is arranged between the integrated antenna and the means for shielding.

8. Wafer level package (10"') according to claim 7, wherein the dielectric (14d, 14d', 14d") is perforated.

9. Wafer level package (10"') according to one of the preceding claims, wherein the integrated antenna (14a, 14a') includes at least two antenna elements.

10. Wafer level package (10"') according to one of the preceding claims, wherein the chip layer (12') includes a plurality of chips (12).

11. Wafer level package (10"') according to one of the preceding claims, wherein the wafer level package (10, 10', 10", 10"') includes a lens (19) that is configured to cooperate with the integrated antenna.

12. Wafer level package (10"') according to one of the preceding claims, wherein the means for shielding are formed by a shielding layer;
wherein an isolation layer (20i') is implemented between the redistribution layer (20u') and the chip layer (12').

13. System including the wafer level package (10"') according to one of claims 1 to 12, wherein a further wafer level package is connected to the wafer level package (10"') via the contacting layer (18, 18').

14. Method of manufacturing a wafer level package (10"') with integrated antenna
according to claim 1, comprising:
arranging a contacting layer (18, 18');
arranging a chip layer (12') including at least one chip (12) on the contacting layer (18, 18');
arranging means for shielding (16) on the chip layer (12'); and
arranging an antenna layer (14, 14') on the means for shielding (16);
wherein a redistribution layer (20u'), which electrically connects the at least one chip to the contacting layer (18, 18'), is configured between the means for shielding (16) and the chip layer (12'), and
wherein the chip (12) comprises means for temperature dissipation in the form of a cooling body (18k') on a side opposite to the antenna layer (14, 14').

15. Method according to claim 14, wherein the antenna layer (14, 14') is deposited by means of laminating and/or via planar adhesion and/or via a glass.

16. Method according to claim 14 or 15, wherein the means for shielding are formed by a shielding layer.

## Revendications

1. Encapsulation au niveau de la tranche (10"') avec une antenne intégrée, aux caractéristiques suivantes:
une couche de contact (18, 18');
une couche d'antenne (14, 14') avec l'antenne intégrée; et
une couche de puces (12') disposée entre la couche de contact (18, 18') et la couche d'antenne (14, 14'), comportant au moins une puce,
dans laquelle sont formés, entre la couche d'antenne (14, 14') et la couche de puces (12'), des moyens de blindage (16);
dans laquelle est formée, entre les moyens de blindage (16) et la couche de puces (12'), une couche de recâblage (20u') qui connecte électriquement l'au moins une puce à la couche de contact (18, 8'), et
dans laquelle la puce (12) présente, d'un côté opposé à la couche d'antenne (14, 14'), des moyens de dissipation de température sous forme d'un dissipateur thermique (18k').

2. Encapsulation au niveau de la tranche (10"') selon la revendication 1, dans laquelle les moyens de blindage (16) comportent une plaque de blindage.

3. Encapsulation au niveau de la tranche (10"') selon la revendication 1, dans laquelle une couche d'isolation (20i') est formée entre la couche de recâblage (20u') et la couche de puces (12').

4. Encapsulation au niveau de la tranche (10"') selon l'une des revendications précédentes,
dans laquelle l'antenne intégrée est conçue comme un réseau phasé ou comporte un réseau d'antennes.

5. Encapsulation au niveau de la tranche (10"') selon l'une des revendications précédentes,
dans laquelle la couche de puces (12') comporte un matériau de moulage qui est disposé à côté de l'au moins une puce (12).

6. Encapsulation au niveau de la tranche (10"') selon l'une des revendications précédentes,
dans laquelle l'antenne intégrée (14a, 14a') est connectée à la puce (12) au moyen d'un via (16u') qui ressort à travers d'autres couches,
ou dans laquelle l'antenne intégrée (14a, 14a') est connectée à la puce (12) au moyen d'un couplage électromagnétique.

7. Encapsulation au niveau de la tranche (10"') selon l'une des revendications précédentes,
dans laquelle la couche d'antenne (14, 14') comporte un diélectrique (14d, 14', 14d") qui est disposé entre l'antenne intégrée et les moyens de blindage.

8. Encapsulation au niveau de la tranche (10"') selon la revendication 7, dans laquelle le diélectrique (14d, 14d', 14d") est perforé.

9. Encapsulation au niveau de la tranche (10"') selon l'une des revendications précédentes,
dans laquelle l'antenne intégrée (14a, 14a') comporte au moins deux éléments d'antenne.

10. Encapsulation au niveau de la tranche (10"') selon l'une des revendications précédentes,
dans laquelle la couche de puces (12') comporte une pluralité de puces (12).

11. Encapsulation au niveau de la tranche (10"') selon l'une des revendications précédentes,
dans laquelle l'encapsulation au niveau de la tranche (10, 10', 10", 10"') comporte une lentille (19) qui est conçue pour coopérer avec l'antenne intégrée.

12. Encapsulation au niveau de la tranche (10"') selon l'une des revendications précédentes,
dans laquelle les moyens de blindage sont formés par une couche de plaque de blindage;
dans laquelle une couche d'isolation (20i') est formée entre la couche de recâblage (20u') et la couche de puces (12').

13. Système comportant l'encapsulation au niveau de la tranche (10"') selon l'une des revendications 1 à 12, dans lequel une autre encapsulation au niveau de la tranche est connectée, par l'intermédiaire de la couche de contact (18, 18'), à l'encapsulation au niveau de la tranche (10, 10', 10").

14. Procédé permettant de réaliser une encapsulation au niveau de la tranche (10"') avec une antenne intégrée selon la revendication 1, aux étapes suivantes consistant à:
disposer une couche de contact (18, 18');
disposer une couche de puces (12') comportant au moins une puce (12) sur la couche de contact (18, 18');
disposer des moyens de blindage (16) sur la couche de puces (12'); et
disposer une couche d'antenne (14, 14') sur les moyens de blindage (16);
dans lequel est formée, entre les moyens de blindage (16) et la couche de puces (12'), une couche de recâblage (20u') qui connecte électriquement l'au moins une puce à la couche de contact (18, 8'), et
dans lequel la puce (12) présente, d'un côté opposé à la couche d'antenne (14, 14'), des moyens de dissipation de température sous forme d'un dissipateur thermique (18k').

15. Procédé selon la revendication 14, dans lequel la couche d'antenne (14, 14') est appliquée au moyen d'un laminage et/ou par l'intermédiaire d'un adhésif plan et/ou par l'intermédiaire d'un verre.

16. Procédé selon la revendication 14 ou 15, dans lequel les moyens de blindage sont formés par une couche de plaque de blindage.
